# FASCICULE DE BREVET EUROPEEN

(11) **EP 0 554 191 B1**
(45) Date de publication et mention de la délivrance du brevet: **03.12.1997**
(21) Numéro de dépôt: 93420032.0
(22) Date de dépôt: 25.01.1993
(51) Int. Cl.: H01L 27/082, H01L 23/62, H02H 3/20

(54) **Composant de protection pour un circuit dans une automobile**
Schutzelement für eine Schaltung in einem Automobil
Protection component for a circuit in an automobile

(30) Priorité: 31.01.1992 FR 9201311
(43) Date de publication de la demande: 04.08.1993
(73) Titulaire: SGS-THOMSON MICROELECTRONICS S.A., 94250 Gentilly (FR)
(72) Inventeur: Pezzani, Robert, F-37210 Vouvray (FR)
(74) Mandataire: de Beaumont, Michel

(56) Documents cités:
- EP-A- 0 318 404

## Description

La présente invention concerne un circuit de protection, plus particulièrement adapté à la protection de circuits intégrés montés dans des automobiles.

Les véhicules automobiles sont alimentés par des batteries dont la tension est normalisée, généralement à 12 V pour les véhicules de tourisme et à 24 V pour les poids lourds. Les composants de protection destinés à éviter la transmission de surtensions par les fils d'alimentation de circuits électroniques auront donc généralement des seuils de déclenchement choisis dans des plages de 20 à 40 volts, de façon à laisser passer la tension d'alimentation normale, qui peut fluctuer autour de la valeur moyenne, et à dériver des surtensions accidentelles, particulièrement fréquentes en milieu automobile et qui peuvent résulter notamment des commutations brutales provoquées par des rupteurs.

En outre, un circuit électronique réalisé sous forme de circuit intégré peut être détruit si la polarité est inversée entre ses bornes d'alimentation, accident particulièrement susceptible de survenir dans le domaine automobile où les réparations ne sont généralement pas effectuées par des électroniciens mais par des mécaniciens.

On cherche donc à se protéger, en plus des surtensions susmentionnées, d'une éventuelle inversion de polarité de la batterie résultant d'une erreur de connexion. On notera que l'une des sources possibles d'apparition de surtension réside dans une déconnexion intempestive de la batterie tandis que l'alternateur de l'automobile est en fonctionnement. Dans ce cas, toute l'énergie fournie par l'alternateur, au lieu d'être absorbée par la batterie, est envoyée dans le circuit sous une tension élevée qui peut atteindre la centaine de volts. Ce phénomène est couramment désigné dans la technique par le terme anglo-saxon "Load Dump".

La solution classique pour éviter ces divers inconvénients consiste à placer une diode de redressement en série avec la batterie. Cette diode évite une circulation de courant en sens inverse en cas d'inversion de la batterie. Cette diode est généralement protégée par une diode à avalanche en parallèle. En effet, dans la pratique usuelle, les diodes destinées à fonctionner en avalanche présentent une dissipation relativement élevée en direct et l'on sépare le rôle de la diode de protection série de celui de la diode avalanche. Pour éviter les problèmes du type Load Dump ou autre surtension sur la ligne, on place classiquement une diode à avalanche entre la ligne d'alimentation et la ligne de référence (généralement la masse) constituée par le châssis de l'automobile. Cette diode à avalanche doit pouvoir absorber des énergies élevées survenant dans le cas du Load Dump.

Un autre type de composant semiconducteur monolitique de protection est décrit dans FR-A-318404.

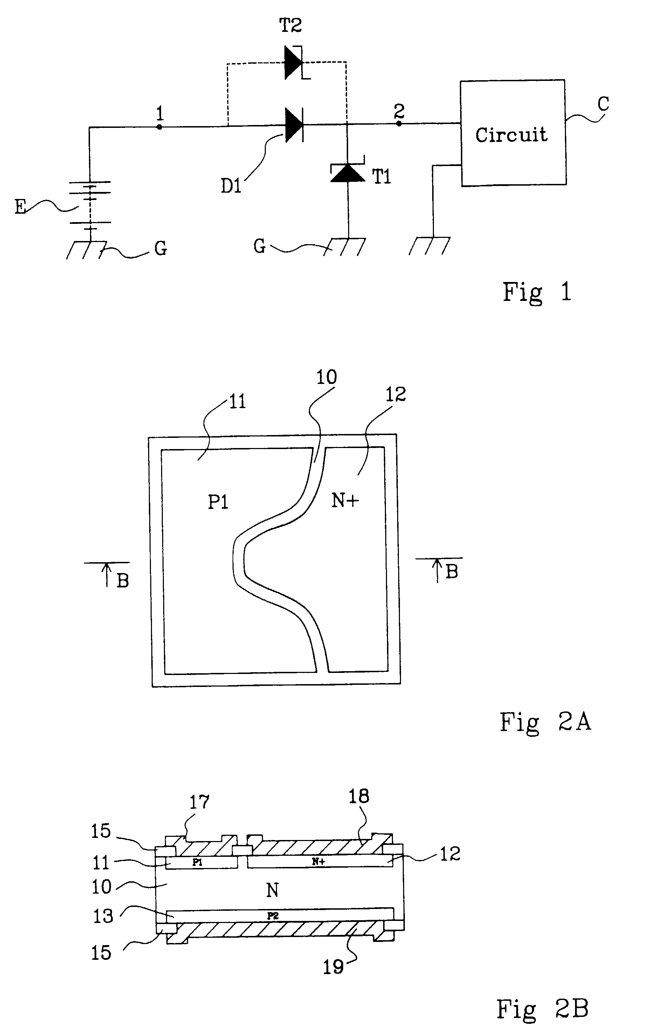

La figure 1 illustre ce mode de protection classique, assuré par trois composants discrets. Une batterie E fournit une tension entre une borne 1 et la masse G. Cette batterie est reliée à la borne d'entrée 2 d'un circuit électronique C à protéger, par exemple un circuit de commande de lève-vitre, par l'intermédiaire de l'ensemble de composants de protection comprenant une diode de redressement en série D1, une diode à avalanche T2 en parallèle sur la diode D1 et une diode à avalanche T1 disposée entre la borne 2 et la masse.

La présente invention vise à réaliser l'ensemble des composants T2, D1 et T1 par un composant monolithique tout en gardant les avantages d'une faible chute de tension en direct entre les bornes 1 et 2.

Les avantages d'une telle réalisation monolithique apparaîtront clairement à l'homme de l'art et comprennent notamment la réduction des coûts et l'élimination d'éventuelles erreurs de montage.

Pour atteindre cet objet, la présente invention telle que revendiquée dans la revendication 1 prévoit un composant semiconducteur monolithique de protection muni d'une borne d'entrée, d'une borne de sortie et d'une borne de référence, comprenant, entre la borne d'entrée et la borne de sortie, une première diode d'une première polarité présentant une faible dissipation en direct et une tension de claquage en inverse de l'ordre de 20 à 40 volts, et, entre la borne de sortie et la borne de référence, une deuxième diode de protection de même polarité. La première diode est réalisée sous forme latérale entre deux électrodes de la face avant du composant et la deuxième diode est réalisée sous forme verticale entre une électrode de la face avant du composant et une électrode de face arrière.

Selon un mode de réalisation de la présente invention, le composant comprend un substrat d'un premier type de conductivité ; sur la face avant du substrat, une première région du deuxième type de conductivité et une deuxième région du premier type à haut niveau de dopage, ces première et deuxième régions ayant des profils sensiblement complémentaires ; et sur la face arrière du substrat, une troisième région du deuxième type de conductivité occupant pratiquement toute ladite face arrière.

Selon un mode de réalisation de la présente invention, le substrat a un niveau de dopage de l'ordre de 10¹⁷ à 10¹⁸ atomes/cm³.

Selon un mode de réalisation de la présente invention, la limite entre les première et deuxième régions est digitée.

Selon un mode de réalisation de la présente invention, la face arrière, métallisée, est montée sur un radiateur.

On notera qu'avec cette structure, bien que la première diode soit réalisée sous forme latérale, étant donné le niveau de dopage relativement élevé du substrat et sa relativement grande épaisseur ainsi que la digitation éventuelle de la diode latérale, on obtient une première diode ayant une faible consommation en direct et une caractéristique souhaitée en inverse.

Ces objets, caractéristiques, et avantages ainsi que d'autres de la présente invention seront exposés en détail dans la description suivante de modes de réalisation particuliers faite en relation avec les figures jointes parmi lesquelles :
la figure 1 représente un schéma classique de protection d'un circuit électronique pour l'automobile ;
la figure 2A représente une vue de dessus schématique d'un mode de réalisation d'un composant monolithique selon la présente invention, cette vue de dessus ne présentant que l'allure des jonctions ; et
la figure 2B représente une vue en coupe schématique selon la ligne BB du composant de la figure 2A.

Dans les figures 2A et 2B, comme cela est classique dans le domaine de la représentation des composants semiconducteurs, les dimensions ne sont pas tracées à l'échelle mais sont arbitrairement dilatées pour améliorer la lisibilité des figures et en faciliter le tracé. En outre, les coins de jonction sont représentés avec des angles droits alors que, en pratique, ces coins de jonction auront des allures arrondies résultant des étapes de diffusion.

Dans le mode de réalisation des figures 2A et 2B, un composant monolithique selon la présente invention est constitué à partir d'un substrat 10 de type N dont l'épaisseur correspond à l'épaisseur classique d'une plaquette de silicium, c'est-à-dire de l'ordre de 0,3 mm. Dans une première région de la face supérieure du substrat est formée une région 11 de type P, appelée P₁, et dans la partie sensiblement complémentaire est formée une région 12 de type N, appelée N⁺, cette région 12 ayant un niveau de dopage élevé devant celui de la région 10. Dans la face inférieure du substrat est formée une région 13 de type P, appelée P₂. Les couches désignées par la référence 15 sont des couches isolantes, ayant éventuellement servi au masquage de formation des régions 11, 12 et 13, et sont couramment en oxyde de silicium. Les surfaces apparentes des régions 11, 12 et 13 sont respectivement revêtues de métallisations 17, 18 et 19. Les métallisations 17, 18 et 19 sont destinées à être connectées respectivement aux bornes 1, 2 et G décrites en relation avec la figure 1.

Dans ce composant, l'ensemble des diodes D1 et T2 est formé entre les métallisations 17 et 18 par la jonction entre les régions P₁ et N. La diode à avalanche T1 est formée entre les électrodes 18 et 19 par la jonction NP₂.

On va montrer que, malgré le préjugé généralement lié à l'utilisation de diodes latérales, la diode latérale P₁NN⁺ entre les électrodes 17 et 18 présente une faible chute de tension en direct et que le composant obtenu permet un bon ajustement des tensions d'avalanche au niveau de protection requis, une limitation des effets parasites (liés au transistor P₁NP₂) et une bonne tenue en énergie.

On notera au préalable que, dans le cas d'une diode à avalanche, la tension de claquage de la jonction est principalement définie par le niveau de dopage de la couche la moins dopée formant la jonction. Ainsi, dans la structure de la figure 2B, pour les diodes à avalanche T2 (jonction P₁N) et T1 (jonction P₂N), la tension d'avalanche est principalement déterminée par le niveau de dopage de la région N. En effet, il est bien connu que, quand on diffuse une couche, telle que les couches P₁ et P₂ dans une région du type de conductivité opposée, l'opération est en pratique possible seulement si l'on vise à atteindre des niveaux de dopage des régions diffusées plus élevés que le niveau de dopage de la région dans laquelle ces couches sont diffusées. Ainsi, pour atteindre comme on l'a indiqué précédemment, une tension d'avalanche de l'ordre de 20 à 40 volts, la région N 10 doit être relativement fortement dopée, c'est-à-dire avoir une résistivité de l'ordre de 20 milliohms à 0,1 ohms-cm (ou un niveau de dopage de 10¹⁷ à 10¹⁸ atomes par cm³).

Par ailleurs, du fait que la couche N 10 constitue le substrat du composant monolithique selon l'invention, son épaisseur après formation des régions P₁ et P₂, entre ces régions P₁ et P₂, est supérieure ou égale à 0,2 mm. Compte tenu de la valeur de la résistivité et de l'épaisseur de la couche N, la résistance d'accès de la diode P₁NN⁺ en direct est faible. En effet, cette résistance est proportionnelle à la résistivité de la région 10 et inversement proportionnelle à son épaisseur. En outre, on a montré en figure 2A que, en vue de dessus, la région N⁺ 12 forme un doigt pénétrant dans la région P₁ de façon à rallonger la longueur de jonction. Cette longueur de jonction pourrait être encore rallongée en augmentant l'interdigitation. Une augmentation de l'interdigitation contribue également à la réduction de la résistance d'accès. Ainsi, on obtient pour la diode latérale P₁NN⁺ des performances de chute de tension en direct très convenables malgré cette configuration latérale. Par exemple, on aura des valeurs de chute de tension en direct V_{f} inférieures à 1,1 V pour une densité de courant de 1 A/mm² et inférieure à 1,5 V pour une densité de courant de 4 A/mm².

Pour les mêmes raisons que celles énoncées précédemment, le fonctionnement en avalanche de la diode N⁺NP₁ est peu affecté par sa structure latérale en ce qui concerne sa tenue en surcharge inverse. En effet, les règles relatives aux valeurs d'épaisseur et de résistivité précédemment mentionnées conduisent à des valeurs de robustesse d'environ 400 W/cm², ce qui est très voisin de ce que donne une structure classique verticale.

Le point de fonctionnement critique de la structure proposée correspond au cas où la diode D1 (P₁NN⁺) est sollicitée en direct alors que la diode T1 (jonction P₂N) est en inverse et n'est pas en avalanche. C'est le cas de fonctionnement normal où le circuit à protéger consomme un courant pour commander un organe de la voiture (moteur lève-vitre, par exemple) sous l'action de la tension de batterie. Dans ces conditions, on voit qu'il existe un transistor parasite P₁NP₂ dont le courant de base I_{b} est le courant délivré au circuit protégé et dont le courant de collecteur est le courant de fuite de la jonction P₂N. En fait, on constate que le gain du transistor parasite est inférieur ou égal à 0,01 à fort courant. Cela est tout à fait acceptable et résulte du fait susmentionné de l'épaisseur élevée et de la faible résistivité de la région N 10. On notera que le transistor à faible gain parasite est obtenu sans prévoir d'étapes telles que l'introduction de pièges par diffusion d'or ou de platine ou tout autre technologie connue. Ceci est tout particulièrement important pour le fonctionnement du dispositif car dans le cas classique où la structure PNP présenterait un effet transistor significatif avec un gain supérieur à 0,1 ou à 1, la structure proposée ne serait pas viable pour la fonction envisagée.

On constate, toujours pour les mêmes raisons, que le temps de recouvrement de la diode D1 est naturellement rapide (inférieur à 0,5 microseconde).

Selon un autre avantage de la présente invention, la jonction NP₂ présente une bonne tenue en surcharge. En effet, cette jonction doit protéger un circuit intégré contre des parasites de forte énergie (par exemple cas du Load Dump). Cette énergie peut être de plusieurs dizaines de joules. Il va de soi qu'un refroidissement optimal de jonction et une taille maximale de la jonction sont favorables. La structure selon l'invention cumule ces avantages puisque la jonction NP₂ occupe le maximum de place permis dans une taille de puce donnée en tenant compte des espaces nécessaires aux périphéries de jonction. D'autre part, la jonction est du côté refroidi de la puce puisqu'elle est du côté masse et peut être soudée à un radiateur au potentiel du véhicule. Cette soudure peut s'effectuer sans isolement par rapport au potentiel du châssis ce qui rend cette puce compatible avec des composants à montage en surface de puissance ou des boîtiers traditionnels de type TO220.

## Revendications

1. Composant semiconducteur monolithique de protection muni d'une borne d'entrée (17), d'une borne de sortie (18) et d'une borne de référence (19), comprenant, entre la borne d'entrée (17) et la borne de sortie (18), une première diode (P₁N) d'une première polarité présentant une faible dissipation en direct et une tension de claquage en inverse de l'ordre de 20 à 40 volts, et, entre la borne de sortie (18) et la borne de référence (19), une deuxième diode de protection (NP₂) de polarité opposée, caractérisé en ce que la première diode est réalisée sous forme latérale entre deux électrodes de la face avant du composant et en ce que la deuxième diode est réalisée sous forme verticale entre une électrode de la face avant du composant et une électrode de face arrière.

2. Composant selon la revendication 1, caractérisé en ce qu'il comprend :
un substrat d'un premier type de conductivité (10) ;
sur la face avant du substrat, une première région (11) du deuxième type de conductivité correspondant à la borne d'entrée (17) et une deuxième région (12) du premier type de conductivité à haut niveau de dopage correspondant à la borne de sortie (18), ces première et deuxième régions ayant des profils sensiblement complémentaires ; et
sur la face arrière du substrat, une troisième région (13) du deuxième type de conductivité correspondant à la borne de référence (19) occupant pratiquement toute ladite face arrière.

3. Composant selon la revendication 2, caractérisé en ce que le substrat a un niveau de dopage de l'ordre de 10¹⁷ à 10¹⁸ atomes/cm³.

4. Composant selon la revendication 2, caractérisé en ce que la limite entre les première et deuxième régions est digitée.

5. Composant selon l'une quelconque des revendications 1 à 4, caractérisé en ce que la face arrière, métallisée, est montée sur un radiateur.

6. Application du composant selon l'une quelconque des revendications 1 à 5 à la protection d'un circuit intégré connecté à une batterie de véhicule automobile.

## Patentansprüche

1. Monolithisches Halbleiter-Schutzelement mit einem Eingangsanschluß (17), einem Ausgangsanschluß (18) und einem Referenzanschluß (19), das zwischen dem Eingangsanschluß (17) und dem Ausgangsanschluß ((18) eine erste Diode (P1N) einer ersten Polarität, die eine geringe Leitung in Vorwärtsrichtung und eine Durchbruchsspannung in Rückwärtsrichtung in der Größenordnung von 20 bis 40 Volt aufweist, und zwischen dem Ausgangsanschluß (18) und dem Referenzanschluß (19) eine zweite Schutzdiode (NP2) entgegengesetzter Polarität vorgesehen sind, dadurch gekennzeichnet, daß die erste Diode in Lateralform zwischen zwei Elektroden auf der Oberseite des Elementes realisiert ist, und daß die zweite Diode in Vertikalform zwischen einer Elektrode auf der Oberseite des Elementes und einer Elektrode auf der Rückseite realisiert ist.

2. Element nach Anspruch 1, dadurch gekennzeichnet, daß es aufweist:
ein Substrat eines ersten Leitungstypes (10);
auf der Oberseite des Substrates einen ersten Bereich (11) des zweiten Leitungstypes entsprechend dem Eingangsanschluß (17) und einen zweiten Bereich (12) des ersten Leitungstypes mit hoher Dotierung entsprechend dem Ausgangsanschluß (18), wobei der erste und der zweite Bereich im Wesentlichen komplementäre Profile aufweisen,
und auf der Rückseite des Substrates einen dritten Bereich (13) des zweiten Leitungstypes entsprechend dem Referenzanschluß (19), der praktisch die gesamte Rückseite bedeckt.

3. Element nach Anspruch 2, dadurch gekennzeichnet, daß das Substrat ein Dotierungsniveau in der Größenordnung von 10¹⁷ bis 10¹⁸ Atome/cm³ aufweist.

4. Element nach Anspruch 2, dadurch gekennzeichnet, daß die Grenze zwischem dem ersten und dem zweiten Bereich fingerförmig ist.

5. Element nach einem der Ansprüche 1 bis 4, dadurch gekennzeichnet, dass die metallisierte Rückseite auf einer Strahlungsquelle montiert ist.

6. Anwendung eines Elementes nach einem der Ansprüche 1 bis 5 zum Schutz einer integrierten Schaltung, die mit einer Batterie eines Automobiles verbunden ist.

## Claims

1. A protection monolithic semiconductor component having an input terminal (17), an output terminal (18) and a reference terminal (19), including between said input (17) and output (18) terminals, a first diode (P₁N) of a first polarity having a low forward dissipation and a reverse breakdown voltage ranging from approximately 20 to 40 volts and, between said output terminal (18) and said reference terminal (19), a second protection diode (NP₂) having the opposite polarity, characterized in that said first diode is laterally disposed between two electrodes of the front surface of the component, the second diode being vertically disposed between an electrode on the front surface of said component and an electrode on the rear surface.

2. A component according to claim 1, characterized in that it includes:
a substrate of a first conductivity type (10) ;
on the front surface of said substrate, a first region (11) of the second conductivity type corresponding to the input terminal (17) and a second highly doped region (12) of the first conductivity type corresponding to the output terminal (18), said first and second regions having substantially complementary profiles; and
on the rear surface of the substrate, a third region (13) of the second conductivity type corresponding to the reference terminal (19) occupying practically the whole rear surface area.

3. A component according to claim 2, characterized in that said substrate has a doping level of approximately 10¹⁷ to 10¹⁸ atoms/cm³.

4. A component according to claim 2, characterized in that the limit between said first and second regions is digitized.

5. A component according to any of claims 1 to 4, characterized inthat the rear surface area is metallized and mounted on a heat sink.

6. Application of the component according to any of claims 1 to 5 for the protection of an integrated circuit connected to the battery of an automobile vehicle.
